# EUROPÄISCHE PATENTSCHRIFT

(11) **EP 0 962 674 B1**
(45) Veröffentlichungstag und Bekanntmachung des Hinweises auf die Patenterteilung: **04.08.2004**
(21) Anmeldenummer: 99110453.0
(22) Anmeldetag: 29.05.1999
(51) Int. Cl.: F16C 33/12

(54) **Gleitlager und Verfahren zu seiner Herstellung**
Sliding bearing shell and method of making the same
Coussinet de palier lisse et son procédé de fabrication

(30) Priorität: 02.06.1998 DE 19824310
(43) Veröffentlichungstag der Anmeldung: 08.12.1999
(73) Patentinhaber: Federal-Mogul Wiesbaden GmbH & Co.KG, 65201 Wiesbaden (DE)
(72) Erfinder: Andler, Gerd, 60594 Frankfurt (DE); Heinss, Jens-Peter, Dr., 01157 Dresden (DE); Goedicke, Klaus, 01307 Dresden (DE); Metzner, Christoph, 01474 Pappritz (DE)

(56) Entgegenhaltungen:
- DE-A- 3 606 529
- GB-A- 2 271 780
- US-A- 3 652 325

## Beschreibung

Die Erfindung betrifft ein Gleitlager, mit einem Trägerkörper und mit mindestens einer metallischen Gleitschicht, die mittels Elektronenstrahlbedampfung aufgebracht ist. Die Erfindung bezieht sich auch auf ein Verfahren zur Herstellung eines Gleitlagers mit einer solchen Gleitschicht gemäß dem Oberbegriff des Patentanspruchs 4.

Gleitlager sind z.B. Radiallager, Axiallager und Axial-Radiallager, wobei der Funktionsbreich in ebener oder gekrümmter Form vorliegt, beschichtet im Fertigzustand oder in einem Zwischenstadium wie zum Beispiel als Halbzeug (Bänder oder Bandabschnitte in ebener Form).

Allgemein bestehen derart eingesetzte Gleitlager aus Mehrschichtverbundsystemen folgenden Aufbaues: Stahlstützkörper als Trägerwerkstoff, Lagermetallschicht aus einer Cu-, Al- oder Weißmetall-Legierung und einer sogenannten Lauf- oder Drittschicht oder Gleitschicht, die entweder durch ein galvanisches Verfahren (E. Römer: Dreistofflager aus GLYCO 40: GLYCO-Ingenieurbericht 8/67) oder durch einen Kathodenzerstäubungsprozeß (Sputtern) aufgebracht werden kann, wie dies in der EP 0 256 226 B1 beschrieben ist. Nachteilig bei den galvanisch aufgebrachten Schichten, meist auf Pb- oder Sn-Basis, ist die oftmals nicht ausreichende Korrosionsbeständigkeit bzw. ihre geringe Verschleißbeständigkeit. Weiterhin ist der Galvanikprozeß an sich aus Umweltgesichtspunkten als kritisch anzusehen.

Werden die Laufschichten mittels der Sputter-Technik aufgebracht, stellt dies aufgrund der hierbei realisierbaren geringen Abscheidungsraten und des hohen anlagentechnischen Aufwandes einen erheblichen Kostenfaktor für das komplette Gleitlager dar.

Weiterhin ist aus DE 43 90 686 T1 bekannt, daß hinsichtlich ihrer Oberflächenstruktur (pyramidenförmige Kristallkörner an der Oberfläche der galvanisch abgeschiedenen Pb-Schicht) diese besonders gearteten Gleitschichten exzellente Blockier- und Ermüdungsfestigkeit aufweisen. Zurückgeführt wird dieser Sachverhalt auf eine gute Ölrückhaltung bzw. auf eine Zerstreuung und eine Verminderung einer konzentriert aufgebrachten Last durch die pyramidenförmigen Kristallkörner der Oberfläche. Als Nachteile bei diesem Verfahren müssen angesehen werden, daß wiederum ein galvanischer Prozeß mit all seinen Nachteilen Einsatz findet bzw. der Prozeß zur Realisierung dieser besonderen Oberflächenstruktur recht aufwendig ist, weil es sich um einen Mehrstufenprozeß mit einer zusätzlichen Wärmebehandlung handelt. Außerdem besteht die Oberflächenschicht aus einer hinsichtlich ihrer Toxizität nicht unkritischen Bleilegierung.

In der DE 196 08 028 A1 wird ebenfalls ein spezieller Gleitflächenaufbau beschrieben, der sich positiv auf die Gleiteigenschaften auswirkt. Hierbei wird der Freßempfindlichkeit der Oberfläche zum einen durch sechseckpyramidenförmige Metallkristalle in der Oberfläche bzw. durch den Einbau von Sauerstoff. Phosphor usw. in die Flanken der Pyramiden (Aufhärtungseffekt) begegnet. Dieses Verfahren findet ausschließlich Anwendung bei Eisenbasislegierungen, wobei die besonders strukturierte Gleitfläche aus Fe-Kristallen besteht. Ein typischer Anwendungsfall ist die Beschichtung von Kolbenbolzen. Derartige Legierungen sind für Gleitlager auf Grund der tribologischen Eigenschaften nicht einsetzbar.

Weiterhin ist aus DE 195 14 835 A1 bzw. 195 14 836 A1 bekannt, mittels Elektronenstrahlbedampfung Gleitschichten auf konkav gekrümmten Gleitlagern abzuscheiden. Mit diesem Verfahren ist es möglich, bei Einstellung bestimmter Verfahrensparameter spezielle Schichtdickenprofile über den Umfang des Gleitlagers herzustellen. Es finden sich in diesen Schriften keine Hinweise auf eine mittels dieses Verfahrens herstellbare besondere Oberflächentopografie. Für eine Vielzahl von Anwendungen sind die damit erzielbaren tribologischen Eigenschaften jedoch nicht ausreichend.

Aus der DE 36 06 529 A1 ist ein Verfahren zur Herstellung von Schichtwerkstoffen oder Schichtwerkstücken durch Aufdampfen mindestens eines metallischen Werkstoffs auf ein metallisches Substrat bekannt, bei dem ebenfalls ein Elektronenstrahlbedampfungsverfahren für das Aufbringen der Gleitschicht eingesetzt wird. Das Verfahren findet unter Restgasatmosphäre bei Drücken im Bereich von 10⁻² - 10⁻³ mbar statt, wobei der Werkstoff gleichzeitig mit dem Aufdampfen dispersionsgehärtet bzw. dispersionsverfestigt wird. Es werden Beschichtungsraten von etwa 0,3 µm/s eingestellt. Während des Aufdampfens wird das Substrat auf eine Temperatur zwischen 200°C und 800°C gehalten. Beim Aufdampfen von Aluminiumlegierungen liegt die Temperatur des Substrates bei 200°C bis 300°C und bei Kupfer-Blei-Legierungen im Bereich von 500°C bis 700°C. Aussagen über die Topografie der mit diesem Verfahren hergestellten Gleitschichten werden nicht gemacht. Die Belastbarkeit der nach diesem Verfahren hergestellten Schichten ist deutlich besser als die mit pulvermetallurgischen Verfahren hergestellten Schichten. Nach diesem Verfahren hergestellte Gleitlager weisen in vielen Anwendungsfällen eine nicht ausreichende Verschleißbeständigkeit auf. Bei dieser Anmeldung steht im Vordergrund, durch eine Dispersionsverfestigung. z.B. durch Erzeugen von Oxiden während des Bedampfens einen definierten Hartphasenanteil in der Gleitschicht zu erzeugen. Eine Optimierung der Oberflächengestalt wird nicht erwähnt.

Die zuvor diskutierten drei Dokumente können jeweils als gattungsbildend angesehen werden.

Aufgabe der Erfindung ist es, ein Gleitlager zu schaffen, dessen Gleitschicht bezüglich der Verschleißbeständigkeit deutlich verbesserte Eigenschaften gegenüber galvanisch aufgebrachten Gleitschichten sowie gegenüber nach herkömmlichen Elektronenstrahlbedampfungsverfahren aufgebrachten Gleitschichten aufweist. Es ist auch Aufgabe der Erfindung, ein Verfahren zur Herstellung solcher Gleitlager bereitzustellen, das einfach, kostengünstig und umweltfreundlich ist.

Das Gleitlager ist dadurch gekennzeichnet, daß die Oberfläche der Gleitschicht runde Erhebungen und Senken aufweist, wobei die Erhebungen bezogen auf die horizontale Schnittebene A einen Flächenanteil von 30-50 %, bezogen auf die Gesamtfläche des Gleitlagers, einnehmen, wobei die Schnittebene in der Höhe liegt, bei der die Summe der im Vertikalschnitt erhaltenen Flächenanteile der Erhebungen gleich der Summe der entsprechenden Flächenanteile der Senken ist, daß die runden Erhebungen in Draufsicht einen Durchmesser D von 3-8 µm aufweisen, wobei sich dieser Wert bei in Draufsicht nicht kreisrunden Erhebungen und Senken auf den maximalen Durchmesser bezieht, und daß die Oberfläche eine Rauheit von R_{z} = 3-7 µm aufweist.

Vorteilhafterweise sind die Erhebungen kreisrund bis oval ausgebildet. Der Begriff rund bezieht sich nicht nur auf die Gestalt der Erhebungen und Senken in Draufsicht, sondern auch auf den vertikalen Querschnitt der Erhebungen und Senken.

Es hat sich herausgestellt, daß Erhebungen, die von Anfang an rund sind, gegenüber den bekannten pyramidenförmigen spitzen Erhebungen den Vorteil aufweisen, daß der Einlaufvorgang für die Gleitpartner schonender vonstatten geht. Ursache hierfür ist, daß die spezifische Belastung bei runden Erhebungen geringer ist als bei spitzen pyramidenförmigen, weil runde einen größeren tragenden Flächenanteil aufweisen. Die runden Erhebungen werden weitaus geringer abgetragen als dies bei spitzen Erhebungen der Fall ist mit der Folge, daß die Tiefe der Vertiefungen in der Einlaufphase nur geringfügig abnimmt und unter normalen Betriebsbedingungen länger erhalten bleibt, wodurch die Ölrückhaltung in den Vertiefungen ebenfalls über längere Zeit gewährleistet wird. Diese positiven Effekte tragen maßgeblich zum verbesserten Verschleißverhalten bei.

Weitere Vorteile dieser Topografie bestehen darin, daß im Falle eines Betriebes des Gleitlagers im Mischreibungsgebiet (Festkörper/Festkörperkontakt) Reibleistungsverluste dadurch verringert werden, daß nicht die gesamte Lageroberfläche, sondern nur die erhabenen Bereiche im Festkörperkontakt stehen. Dieser Vorteil wird dadurch unterstützt, daß der Flächenanteil der runden Erhebungen nur 30-50 % beträgt.

Der Trägerkörper, auf dem die Gleitschicht aufgebracht ist, besteht vorteilhafterweise aus einem Verbundwerkstoff, der einen Stahlrücken und eine aufgesinterte, aufgegossene oder aufplattierte Lagermetallegierung aufweist. Gegebenenfalls kann auch noch eine Diffusionssperrschicht vorgesehen sein.

Die Gleitschicht kann aus einer Kupfer- oder Aluminiumlegierung bestehen.

Das erfindungsgemäße Verfahren ist dadurch gekennzeichnet, daß ein Trägerkörper mit einer Rauheit von R_{z} ≤ 2 µm verwendet wird, daß die Bedampfung bei einem Druck < 0,1 Pa durchgeführt wird, daß die Bedampfungsrate auf dem Gleitlager senkrecht über der Verdampfungsquelle mindestens 100 nm/s beträgt und daß die Temperatur des zu beschichtenden Trägerkörpers zwischen 75 % und 95 % der absoluten Schmelztemperatur-der niedrigstschmelzenden Komponente der Gleicschichtlegierung beträgt.

Es hat sich überraschend herausgestellt, daß sich mit den eingestellten Parametern die erfindungsgemäße Topographie einstellt.

Ein störender Effekt setzt ein, wenn die Temperatur des Substrates über den Wert von 95 % der niedrigstschmelzenden Legierungsphase erhöht wird, weil dann die Diffusion der niedrigstschmelzenden Phase so stark zunimmt, daß eine Glättung der Oberfläche eintritt. Wenn die Temperatur unterhalb von 75 % der niedrigstschmelzenden Legierungsphase liegt, bildet sich eine unerwünschte Stengelstruktur aus, die zu einer höheren Verschleißrate führt, weil die tragenden Flächenanteile deutlich geringer sind.

Die Rauheit des Trägermaterials hat möglicherweise auf die Topografie insofern einen Einfluß, als die Erhebungen des Trägerkörpers Kondensationspunkte bilden können, die das Wachstum der Beschichtung beeinflussen. Der Einfluß der Rauheit des Trägerkörpers ist umso größer, je geringer die Dicke der Gleitschicht ist, wobei es auch noch Abhängigkeiten vom Material des Trägerkörpers gibt. Vorzugsweise wird daher die Oberfläche des Trägerkörpers vor dem Aufbringen der Gleitschicht bearbeitet, so daß die Rauheit R_{z} ≤ 2 µm beträgt.

Das Verfahren zur Herstellung von Gleitlagern ist aber nicht auf Trägerkörper beschränkt, die aus Stahl/CuPbSn-Verbundwerkstoffen bestehen. Es können auch Stahl/Aluminum- oder Stahl/Weißmetall-Verbunde in gleicher Weise beschichtet werden. Als Legierungssysteme können z.B. AlSnPb oder AlSnSi und andere Aluminium-Basislegierungen mittels Elektronenstrahlbedampfung aufgebracht werden. Ebenso sind CuPb-Legierungen geeignet.

Das erfindungsgemäße Verfahren ist besonders kostengünstig und einfacher als beispielsweise Sputterverfahren.

Beispielhafte Ausführungsformen der Erfindung werden nachfolgend anhand der Zeichnungen näher erläutert. Es zeigen:
- Fig. 1: eine elektronenmikroskopische Aufnahme einer gemäß des erfindungsgemäßen Verfahrens aufgebrachten Gleitschicht,
- Fig. 2: einen Schnitt durch die in der Fig. 1 gezeigte Gleitschicht, wobei auch der Trägerkörper dargestellt ist, und
- Fig. 3: ein Diagramm zum Verschleißverhalten von Lagerwerkstoffen.

Gemäß einem bevorzugten Ausführungsbeispiel wird eine CuPbSn-Legierung durch einen Gieß- oder Sinterprozeß auf ein Stahlband (Kohlenstoffgehalt zwischen 0,03 % und 0,3 %) aufgebracht. Nach verschiedenen an sich bekannten Glüh- und Umformprozessen werden aus diesem Band durch Pressen von Bandstücken einer definierten Länge Gleitlagerschalen hergestellt. Nach einer Oberflächenbearbeitung dieser Lager durch Bohren oder Räumen werden die Lagerschalen durch einen galvanischen oder einen PVD-Prozeß mit einer Diffusionssperrschicht aus Nickel oder einer Nickellegierung versehen. Danach wird der Trägerkörper entfettet und in eine Vakuumverdampfungsanlage eingebracht. Hier erfolgt eine weitere Oberflächenreinigungs- bzw. -aktivierung durch einen Zerstäubungsätzprozeß. Im Anschluß daran wird der Trägerkörper durch Elektronenstrahlbedampfen von AlSn20Cu aus einem Verdampfertiegel mittels einer axialen Elektronenkanone beschichtet. Die Schichtdicke der abgeschiedenen AlSn20Cu-Schicht beträgt hierbei (16 ± 4) µm.

Damit sich die oben beschriebene besonders vorteilhafte Oberflächentopographie der AlSn20Cu-Schicht einstellt, sind beim Bedampfungsprozeß folgende Bedampfungsparameter einzuhalten: Der Druck in der Prozeßkammer darf während des Bedampfens den Wert von 0.1 Pa nicht überschreiten. Die Temperatur des Trägerkörpers bei der Beschichtung muß zwischen 190°C und 200°C liegen. Die Leistung der Elektronenkanone wird dabei so gewählt, daß die Abscheidungsrate mindestens 100 nm/s beträgt.

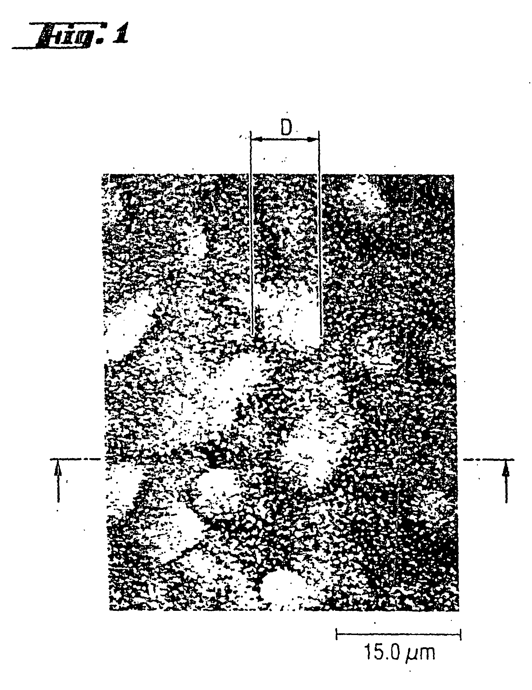

Werden diese Verfahrensparameter eingehalten, entsteht eine Gleitschicht wie sie in Fig. 1 in einer Draufsicht dargestellt ist, die mittels eines Rasterelektronenmikroskopes aufgenommen wurde.

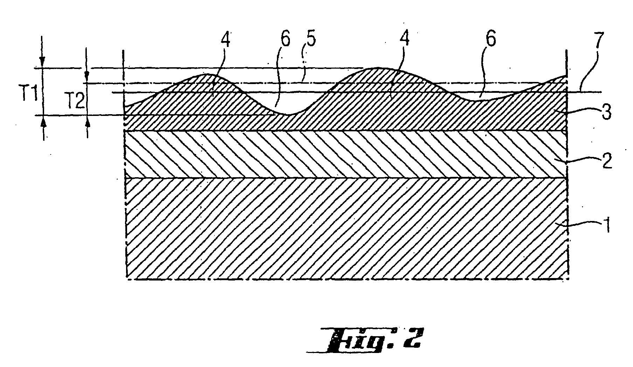

In der Fig. 2 ist ein Schnitt durch die in der Fig. 1 gezeigte Gleitschicht 3 schematisch dargestellt, wobei auch der Trägerkörper mit dem Stahlrücken 1 und die durch einen Gieß- oder Sinterprozeß auf den Trägerkörper 1 aufgebrachte CuPbSn-Legierung 2 dargestellt ist. Die Schnittlinie 7 markiert die Lage der horizontalen Ebene, bei der die Summe der darüberliegenden vertikalen Flächen der Erhebungen 4 gleich der Summe der vertikalen Flächen der Vertiefungen oder Senken 6 ist.

Die Linie 5 veranschaulicht den Betrag der Erhebungen 4, der beim Einlaufvorgang abgetragen wird. Die Tiefe T1 der Vertiefungen 6 nimmt hierbei vom Wert T1 auf den Wert T2 ab, der aber im Vergleich zu den Gleitschichten mit pyramidenförmiger Struktur immer noch deutlich größer ist.

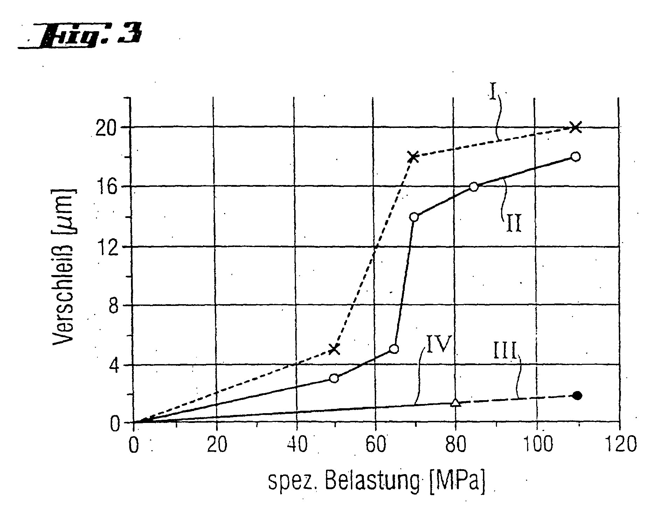

In der Fig. 3 ist das im Underwood-Prüfstand ermittelte Verschleißverhalten von verschiedenen Lagerwerkstoffen dargestellt. In Fig. 3 bedeuten

| | | |
|---|---|---|
| I | CuPbSn | galvanisch abgeschieden |
| | PbSn10Cu2 | |
| II | CuPbSn | galvanisch abgeschieden |
| | PbSn10Cu5 | |
| III | AlSn20Cu0.25 | gesputtert |
| IV | AlSn20Cu0.25 | erfindungsgemäß bedampft. |

Wie Fig. 3 zeigt, setzt bei galvanisch abgeschiedenen Gleitschichten (PbSn10Cu2 bzw. PbSn10Cu5) starker Verschleiß bei spezifischen Belastungen von 50 bzw. 65 MPa ein. Sputterschichten dagegen zeigen einen linearen Verschleiß uber den gesamten Belastungsbereich. Wie Fig. 3 weiter zeigt, liegen die erfindungsgemäß aufgedampften Schichten, insbesondere bei Belastungen < 50 MPa, hinsichtlich ihrer Verschleißwiderstände deutlich über den galvanisch aufgebrachten Schichten und nur geringfügig schlechter als die Sputterschichten.

## Patentansprüche

1. Gleitlager mit einem Trägerkörper und mit mindestens einer metallischen Gleitschicht, die mittels Elektronenstrahlbedampfung aufgebracht ist, **dadurch gekennzeichnet,**
**daß** die Oberfläche der Gleitschicht (3) runde Erhebungen (4) und Senken (6) aufweist, wobei die Erhebungen (4) bezogen auf eine horizontale Schnittebene (7) einen Flächenanteil von 30-50 %, bezogen auf die Gesamtfläche des Gleitlagers, einnehmen, wobei die Schnittebene (7) in der Höhe liegt, bei der die Summe der im Vertikalschnitt erhaltenen Flächenanteile der Erhebungen (4) gleich der Summe der entsprechenden Flächenanteile der Senken (6) ist,
**daß** die runden Erhebungen (4) in Draufsicht einen Durchmesser D von 3-8 µm aufweisen, wobei sich dieser Wert bei in Draufsicht nicht kreisrunden Erhebungen (4) und Senken (6) auf den maximalen Durchmesser bezieht, und
**daß** die Oberfläche eine Rauheit von R_{z} = 3-7 µm aufweist.

2. Gleitlager nach Anspruch 1, **dadurch gekennzeichnet, daß** der Trägerkörper aus einem Verbundwerkstoff besteht, der einen Stahlrücken (1) und eine aufgesinterte, aufgegossene oder aufplattierte Lagermetallegierung (2) aufweist.

3. Gleitlager nach einem der Ansprüche 1 oder 2, **dadurch gekennzeichnet, daß** die Gleitschicht (3) aus einer Kupfer- oder Aluminiumlegierung besteht.

4. Verfahren zur Herstellung eines Gleitlagers mit mindestens einer Gleitschicht aus einer metallischen Legierung, die mittels Elektronenstrahlbedampfung auf einen Trägerkörper aufgebracht wird,
**dadurch gekennzeichnet,**
**daß** ein Trägerkörper mit einer Rauheit von R_{z} ≤ 2 µm verwendet wird,
**daß** die Bedampfüng der Gleitschicht bei einem Druck < 0,1 Pa durchgeführt wird,
**daß** die Bedampfungsrate auf dem Gleitlager senkrecht über der Verdampfungsquelle mindestens 100 nm/s beträgt, und
**daß** die Temperatur des zu beschichtenden Trägerkörpers zwischen 75 % und 95 % der absoluten Schmelztemperatur der niedrigstschmelzenden Komponente der Gleitschichtlegierung beträgt.

## Claims

1. Sliding bearing having a support body and having at least one metallic sliding layer which is applied by means of electron beam vapour deposition,
**characterized in**
**that** the surface of the sliding layer (3) has round elevations (4) and depressions (6), the elevations (4), based on a horizontal sectional plane (7), occupying an area fraction 30-50%, based on the total area of the sliding bearing, the sectional plane (7) being at the height at which the sum of those area fractions of the elevations (4) which are obtained in the vertical section is equal to the sum of the corresponding area fractions of the depressions (6),
**that** the round elevations (4) in plan view have a diameter D of 3-8 µm, this value being based on the maximum diameter in the case of elevations (4) and depressions (6) which are not circular in plan view, and
**that** the surface has a roughness of R_{z} = 3-7 µm.

2. Sliding bearing according to Claim 1, **characterized in that** the support body consists of a laminated material which has a steel back (1) and a bearing metal alloy (2) applied by sintering, by casting or by plating.

3. Sliding bearing according to either of Claims 1 and 2, **characterized in that** the sliding layer (3) consists of a copper alloy or aluminium alloy.

4. Method for the production of a sliding bearing having at least one sliding layer of a metallic alloy which is applied to a support body by means of electron beam vapour deposition,
**characterized in**
**that** a support body having a roughness of R_{z} ≤ 2 µm is used,
**that** the vapour deposition of the sliding layer is carried out at a pressure of < 0.1 Pa,
**that** the vapour deposition rate on the sliding bearing, perpendicularly above the vaporization source, is at least 100 nm/s, and
**that** the temperature of the support body to be coated is between 75% and 95% of the absolute melting point of the lowest-melting component of the sliding layer alloy.

## Revendications

1. Palier lisse comportant un corps de support et au moins une couche de glissement métallique qui est appliquée par vaporisation par faisceau électronique, **caractérisé**
**en ce que** la surface de la couche de glissement (3) présente des protubérances (4) et des creux (6) arrondis, les protubérances (4), rapportées à un plan de coupe horizontal (7) occupant une fraction de surface de 30 à 50 %, sur la base de la surface totale du palier, le plan de coupe (7) se trouvant à la hauteur à laquelle la somme des fractions de surface des protubérances (4) obtenues en coupe verticale est égale à la somme des fractions de surface correspondantes des creux (6),
**en ce que** les protubérances (4) arrondies, en vue de dessus, présentent un diamètre D de 3 à 8 µm, cette valeur, dans le cas de protubérances (4) et de creux (6) qui ne sont pas circulaires ou ronds en vue de dessus, se rapportant au diamètre maximum, et
**en ce que** la surface présente une rugosité R_{z} = 3-7 µm.

2. Palier lisse selon la revendication 1, **caractérisé en ce que** le corps de support se compose d'un matériau composite qui présente une partie arrière ou de dos en acier (1) et un alliage métallique pour palier (2) fritté, coulé ou plaqué.

3. Palier lisse selon l'une des revendications 1 ou 2, **caractérisé en ce que** la couche de glissement (3) se compose d'un alliage de cuivre ou d'aluminium.

4. Procédé de fabrication d'un palier lisse comportant au moins une couche de glissement composée d'un alliage métallique et qui est appliquée sur un corps de support au moyen d'une vaporisation par faisceau électronique, **caractérisé**
**en ce qu'**on utilise un corps de support présentant une rugosité R_{z} ≤ 2 µm,
**en ce que** la vaporisation de la couche de glissement est conduite à une pression < 0,1 Pa,
**en ce que** la vitesse de vaporisation sur le palier lisse perpendiculairement via la source de vaporisation est d'au moins 100 nm/s, et
**en ce que** la température du corps de support à revêtir est comprise entre 75 % et 95 % de la température de fusion absolue du composant à plus bas point de fusion de l'alliage pour couche de glissement.
